# EUROPEAN PATENT APPLICATION

(11) **EP 1 037 288 A2**
(43) Date of publication of application: **20.09.2000**
(21) Application number: 99124402.1
(22) Date of filing: 07.12.1999
(51) Int. Cl.: H01L 41/09, D03D 47/34, B65H 59/22

(54) **Piezoelectric effect actuator in particular for use in textile machines**

(30) Priority: 11.12.1998 IT MI982662
(71) Applicant: NUOVA VAMATEX S.p.A., 24020 Villa di Serio (Bergamo) (IT)
(72) Inventor: Nani, Roberto, 24020 Ranica, Bergamo (IT); Zenoni, Adriano, 24026 Leffe, Bergamo (IT)
(74) Representative: Vatti, Paolo, Dr. Ing.

(57) **Abstract**

The invention relates generally to a actuator in the form of a bimorphous piezoelectric plate consisting of two layers of piezoelectric ceramic material which are electrically insulated and between which a steel support sheet is located. Electrically polarising in a symmetrical manner the layers of piezoelectric ceramic material produces inflection of the plate, which is used to perform an actuating movement or an adjustment or an action. Suitably said plate operates as a lever and the layers of piezoelectric ceramic material thereof are polarised in a symmetrical manner by means of a voltage-modulated electric signal.

According to a more specific aspect, the invention relates to the use of said actuator in a device for braking the weft yarns for weaving looms, in which the piezoelectric plate of the actuator acts on a weft yarn running between said plate and a substantially rigid plate.

## Description

The present invention relates to a piezoelectric effect actuator.

It is known that the piezoelectric effect, which was discovered in 1880 by the Curie brothers, consists in the properties, which some crystalline materials have, of generating on their surface an electric charge which is proportional to a mechanical force applied externally.

The cause of this phenomenon is the asymmetrical crystal structure of these materials: with the application of a mechanical stress, the material is deformed resiliently, the charge centres are separated and free electric charges are deposited on the surfaces of the crystal.

As is known, the piezoelectric effect is also produced in a converse manner, namely applying a potential difference to plates or small blocks of said materials produces forces. It has been thought to use these forces to produce actuators. Natural piezoelectric materials such as quartz and tourmaline are, however, not very suitable for the manufacture of actuators owing to unsatisfactory values of the characteristic coefficients of the material: it is therefore preferred to use polycrystalline ceramic materials.

The advantage of these ceramic materials, referred to as ferroelectric materials, is that some important properties, such as the expansion coefficient, may be controlled by means of suitable mixing of the ingredients. Materials which are commonly used for this purpose are mixtures of lead and magnesium titanium-zirconate, known as PZT and PMN.

On the other hand, these artificial piezoelectric materials are very fragile since they have a consistency which is similar to that of glass and require strong cases and precautionary measures during use and mounting.

If an individual piezoelectric plate is considered, the deformation thereof may be obtained in a direction perpendicular both to the direction of polarisation and to the direction of the electric field. This observation provides the basis for the present invention which relates to an actuator formed by means of a bimorphous piezoelectric plate consisting of two piezoelectric ceramic layers which are electrically insulated and between which a steel support sheet is located.

By electrically polarising in a symmetrical manner the two ceramic layers of the said plate, expansion of one and contraction of the other is obtained, resulting in inflection of the plate itself and the possibility of using this inflection in order to operate a mechanical component, variation in the degree of opening of a pipe, braking of a yarn against a rigid surface with which the plate co-operates, displacement of the valve in proportional valves and many other useful applications. In many of these applications said piezoelectric plate may be advantageously used so as to operate as a single lever or a lever forming part of a series of levers (or lever system).

A field in which the use of actuators of this type has proved to be very interesting is certainly that of textile machines, in particular owing to the very great immediacy in response with which the piezoelectric plate described above reacts to signals, thus satisfying the need for a rapid or very rapid variation in a large number of operating movements, associated with the present increasingly higher speeds of these machines and therefore their parts, devices and accessories.

Although the present invention is generally intended for the actuator defined above, for any application thereof, the Applicant is particularly interested in its use in textile machines and especially in a device for braking the weft yarns of weaving looms.

The invention therefore relates in particular to a device for braking said yarns, of the type comprising a substantially rigid fixed plate and a plate operating as a lever and deformable, upon actuation, so as to engage with a variable force with the fixed plate, acting on a weft yarn running between said plates so as to perform braking thereof, characterised in that said deformable plate consists in an actuator which is formed by means of a bimorphous piezoelectric plate consisting of two piezoelectric ceramic layers which are electrically insulated and between which a steel support sheet is located, wherein said layers of piezoelectric ceramic material are polarised in a symmetrical manner by means of a voltage-modulated electric signal, causing inflection of the plate so as to perform braking in a manner which may be regulated.

Appropriately, said piezoelectric plate may form directly the active braking element of said braking device, co-operating with the fixed plate, or may alternatively actuate it.

The invention is now described in greater detail with reference to the accompanying drawings, which illustrate some embodiments for application of the actuator according to the invention to the braking of weft yarns in textile machines.

In the drawings:
Fig. 1 shows a braking device which uses an actuator according to the invention, consisting in a piezoelectric plate forming directly the active braking element of the device itself;
Fig. 2 shows another embodiment of the braking device according to the invention, in which a piezoelectric plate operates on an oscillating pillar piece forming the active braking element;
Fig. 3 shows a further embodiment of the braking device according to the invention, which uses two piezoelectric plates arranged and operating symmetrically as active braking elements; and
Fig. 4 is the diagram of a braking device according to the invention which uses an actuator with a rotating micropositioning system.

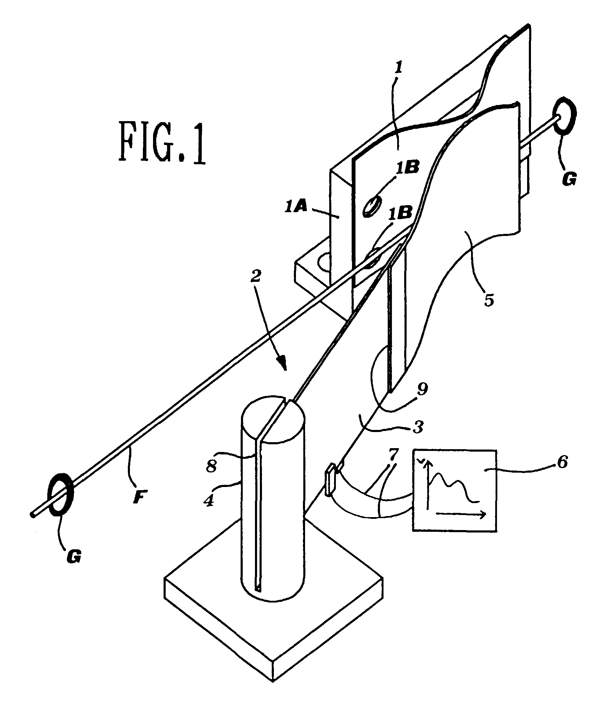

With reference to the drawings, the braking device shown in Fig. 1 consists of a substantially rigid plate 1 which is fixed to a support 1A by means of screws 1B and an actuator 2 in the form of a deformable plate which operates as a lever and presses resiliently, in a manner which may be regulated, against the fixed plate 1, in order to perform the braking of a weft yarn F between yarn guides G of a weaving loom.

According to the invention, the actuator 2 consists of a bimorphous piezoelectric plate 3 formed by two layers of piezoelectric ceramic material which are electrically insulated and between which a steel sheet is located, and a support in the form of a pin 4 in which said plate 3 is fixed at one end, being electrically insulated with respect thereto by means of the arrangement, in between, of layers of insulating material 8, for example "Rulon". The plate 3 terminates at the other end in an end portion 5 made of material which is resilient, yielding and electrically insulated with respect to the plate 3 itself by means of the arrangement, in between, of an insulating layer 9. The end portion 5 interacts with the rigid and fixed plate 1 so as to brake the yarn F. Fixing of the plate 3 in the support 4 may be performed, alternatively, by means of a fork-shaped support which is clamped by screws. Attachment of the end portion 5 to the plate 3 is preferably achieved by bonding.

It is possible to provide a system for adjustment of the position and the force with which the actuator 2 acts on the plate 1 by making the position of the pin-shaped support 4 adjustable - for example by means of rotation.

Voltage-modulated electric signals which are produced by a suitable source and controlled by a microprocessor 6, in the form of micro-impulses and in synchronism with operation of the loom, are supplied by means of wires 7 to the two piezoceramic layers of the plate 3 and cause in very short periods of time the deformations thereof which ensure the desired micro-displacements of the actuator 2.

It is thus possible to control, with a very high degree of response to the most complex requirements which arise at each instant, the action of the actuator 2 itself, and hence braking of the yarn F, during each stage of operation of the loom and in synchronism with its movements.

A braking device such as that described and illustrated also has an extremely simple constructional design and very small overall dimensions. In said device, the actuator according to the invention therefore also provides these considerable advantages - which are particularly useful in weaving looms - to that of precision and rapidity of action.

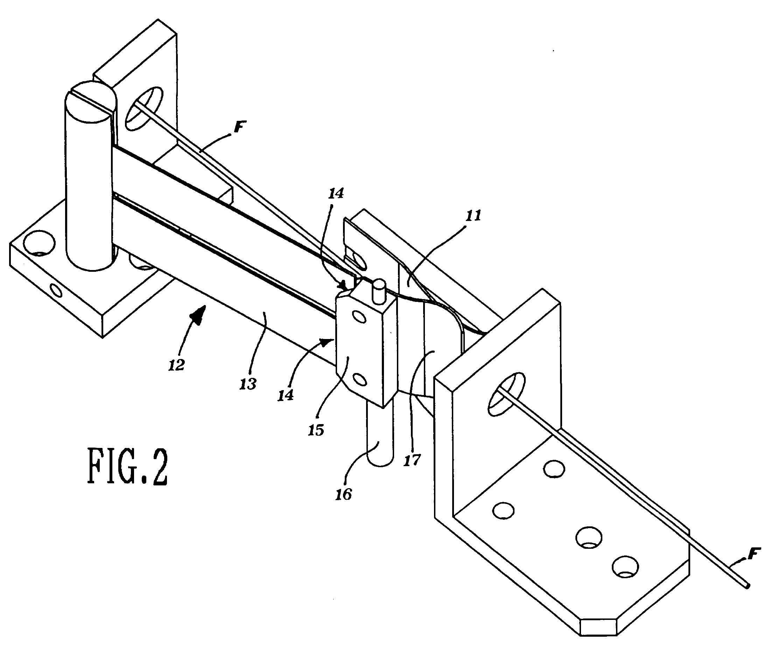

The same advantages arise in the devices with actuators according to the invention illustrated in Figs. 2 to 4.

The device according to Fig. 2 incorporates a modification, consisting in arranging, in the actuator 12, the unattached end of the piezoelectric plate 13 so that it acts on a V-shaped side 14 of a pillar piece 15 which oscillates about 16 and carries a resilient element 17 which is intended to engage with the fixed plate 11, so as to perform braking of the yarn F. The pillar piece 15 is made of electrically insulating material or is electrically insulated, for example by lining with Rulon the cavity of its side 14 with respect to the plate 13. There is thus the possibility of increasing the stroke of the element 17 with respect to the stroke of the free end of the plate 13, depending on the ratio of the distances between the fulcrum 16 and the points where the power and the resistance are applied to the oscillating pillar piece 15, thereby increasing the pressing force on the yarn F (up to about four times) and moreover freeing the plate 13 from any interaction with the yarn F.

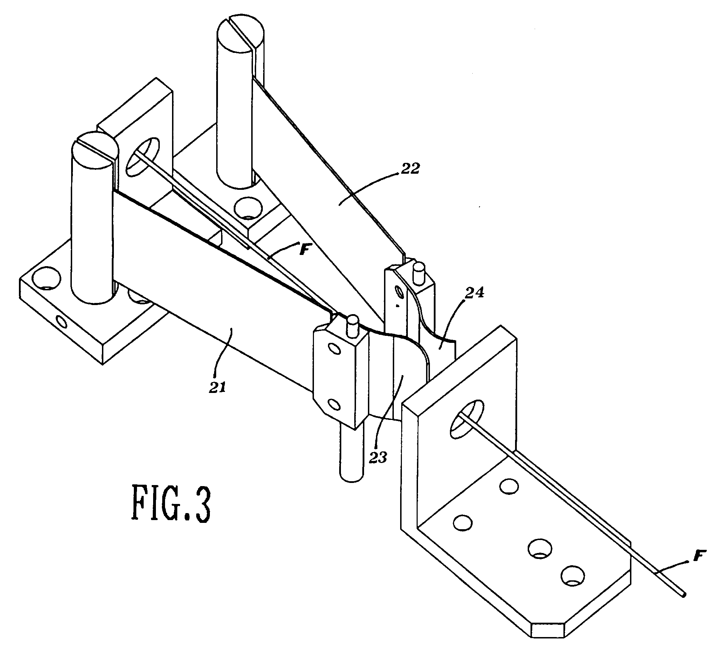

The braking device according to Fig. 3 comprises a pair of piezoelectric plates 21 and 22 which are arranged and operate in a symmetrical manner and between which the yarn F is braked. Both the piezoelectric plates are mounted in a manner similar to that of the plate 13 in Fig. 2, with their resilient end portions 23 and 24 making mutual contact so as to perform braking. As a result of the use of two identical piezoelectric plates which are arranged and operate symmetrically in accordance with the solution of Fig. 3, characterised by total correspondence of shape, size and position with respect to the plane of the yarn F of the plates, it is possible to increase both the pressing force on the yarn F and the opening range of the slit inside which the yarn F itself runs.

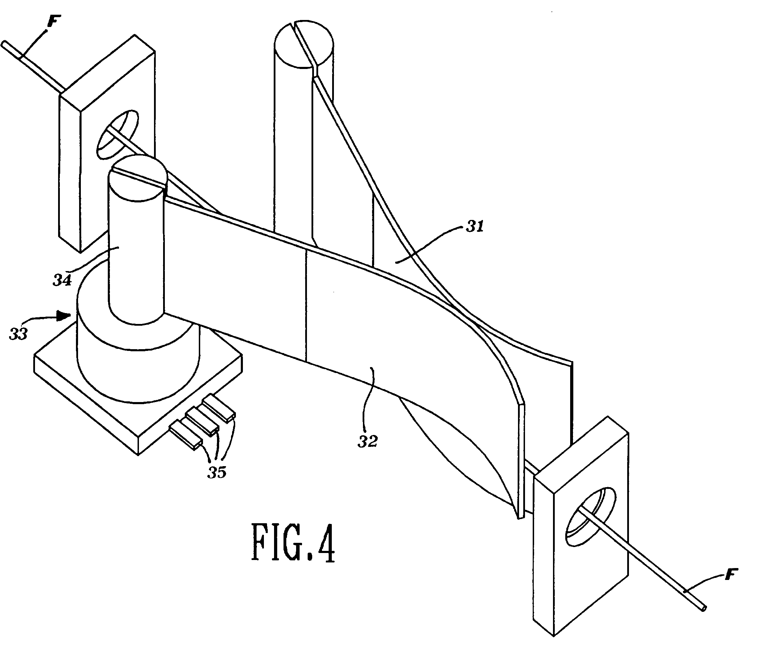

Finally, the braking device according to Fig. 4 also comprises a pair of resilient plates 31 and 32 between which the yarn F is braked. In this embodiment the plate 31 is fixed, while the plate 32 is movable under the control of a piezoceramic actuator 33 to the rotating pin 34 of which it is fixed in cantilever fashion. The actuator 33, which is supplied at 35 by voltage-modulated electric signals, contains a piezoelectric plate which is designed to produce micro-rotations of the pin 34 in one direction and the other, to which variations in the braking force exerted on the yarn F by the resilient plate 32 correspond.

It is understood that the embodiments of the piezoelectric actuator and the braking device for weaving looms considered may be different from those described. These embodiments obviously fall within the scope of the present invention.

## Claims

1. Actuator, characterised in that it is formed by means of a bimorphous piezoelectric plate consisting of two layers of piezoelectric ceramic material which are electrically insulated and between which a steel support sheet is located.

2. Actuator as claimed in Claim 1, wherein said layers of piezoelectric ceramic material are polarised electrically in a symmetrical manner, causing inflection of the plate.

3. Actuator as claimed in Claims 1 and 2, wherein the inflection of the plate is used to perform an actuating movement or an adjustment or an action or the like.

4. Actuator as claimed in Claims 1 to 3, wherein said layers of piezoelectric ceramic material are polarised in a symmetrical manner by means of a voltage-modulated electric signal.

5. Actuator as claimed in Claims 1 to 4, wherein said plate operates as a lever.

6. Actuator as claimed in Claims 1 to 5 for use in a device for braking weft yarns for weaving looms.

7. Actuator as claimed in Claim 6, the said piezoelectric plate of which forms directly the active braking element of said braking device, comprising a passive braking element with which said plate co-operates.

8. Actuator as claimed in Claim 6, the piezoelectric plate of which acts, by means of an amplifying active braking element, on the passive fixed braking element.

9. Actuator as claimed in Claims 1 to 6, wherein two or more piezoelectric plates supplied in parallel by the electric control signals are used.

10. Devices for braking the weft yarns in weaving looms, of the type comprising a substantially rigid fixed plate and a plate operating as a lever and deformable, upon actuation, so to engage with a variable force with the fixed plate, acting on a weft yarn running between said plates, so as to perform braking thereof, characterised in that said deformable plate consists of an actuator as claimed in Claims 1 to 8.

11. Braking device as claimed in Claim 9, wherein said actuator comprises a bimorphous piezoelectric plate consisting of two layers of piezoelectric ceramic material which are electrically insulated and between which a steel sheet is located, and a support in the form of a pin in which said piezoelectric plate is fixed at one end, voltage-modulated electric signals, which are produced by a suitable source and controlled by a microprocessor, in the form of micro-impulses and in synchronism with operation of the loom, being supplied to the two piezoceramic layers of said plate.

12. Braking device as claimed in Claims 10 and 11, wherein said piezoelectric plate terminates at its active end in an end portions made of material which is resilient, yielding and electrically insulating or insulated from the piezoelectric plate which rests on the rigid and fixed plate for braking of the yarn F.

13. Braking device as claimed in Claims 10 and 11, wherein the active end of the piezoelectric plate acts on an oscillating pillar piece which carries a resilient element for engagement of the fixed plate so as to perform braking of the yarn.

14. Braking device as claimed in Claims 10 and 11, comprising a pair of piezoelectric plates which are arranged and operate symmetrically and between which the yarn is braked, each plate operating as an actuator as claimed in Claims 1 to 9.

15. Braking device as claimed in Claims 10 and 11, comprising a pair of resilient plates between which the yarn is braked, one being fixed and one movable under the control of an actuator to the rotating pin of which it is fixed in cantilever fashion, characterised in that the movable plate is controlled by a piezoelectric actuator which is supplied by voltage-modulated electric signals and is designed to produce micro-rotations of said pin in one direction and the other, to which variations in the braking force exerted on the yarn correspond.
